# EUROPEAN PATENT APPLICATION

(11) **EP 1 715 732 A2**
(43) Date of publication of application: **25.10.2006**
(21) Application number: 06008023.1
(22) Date of filing: 18.04.2006
(51) Int. Cl.: H05K 1/02, H05K 3/46

(54) **Printed circuit board structure having a layer at one of its surfaces for dissipating heat by convection**

(30) Priority: 18.04.2005 CN 200510067400
(71) Applicant: ASUSTeK Computer Inc., Peitou Taipei (TW)
(72) Inventor: Chen, Yueh-Chih, Tapei (TW); Chang, Kai-Shun, Tapei (TW)
(74) Representative: Weber, Joachim

(57) **Abstract**

A printed circuit board structure includes a signal reference layer (340) exposed at the surface of the printed circuit board (300). Through the large-area copper material of the signal reference layer (340) having a good heat conduction properties, the heat generated by thermal devices (360) located on the opposite surface of the printed circuit board (300), can be dissipated by convection in the environment surrounding the printed circuit board (300) to achieve a good heat dissipation effect.

## Description

This application claims the benefit of People's Republic of China application Serial No. 200510067400.5 filed April 18, 2005, the subject matter of which is incorporated herein by reference.

### BACKGROUND OF THE INVENTION

### Field of the Invention

The invention relates in general to a printed circuit board structure, and more particularly to a printed circuit board structure in which a large piece of heat conduction material is disposed at the surface of the printed circuit board.

### Description of the Related Art

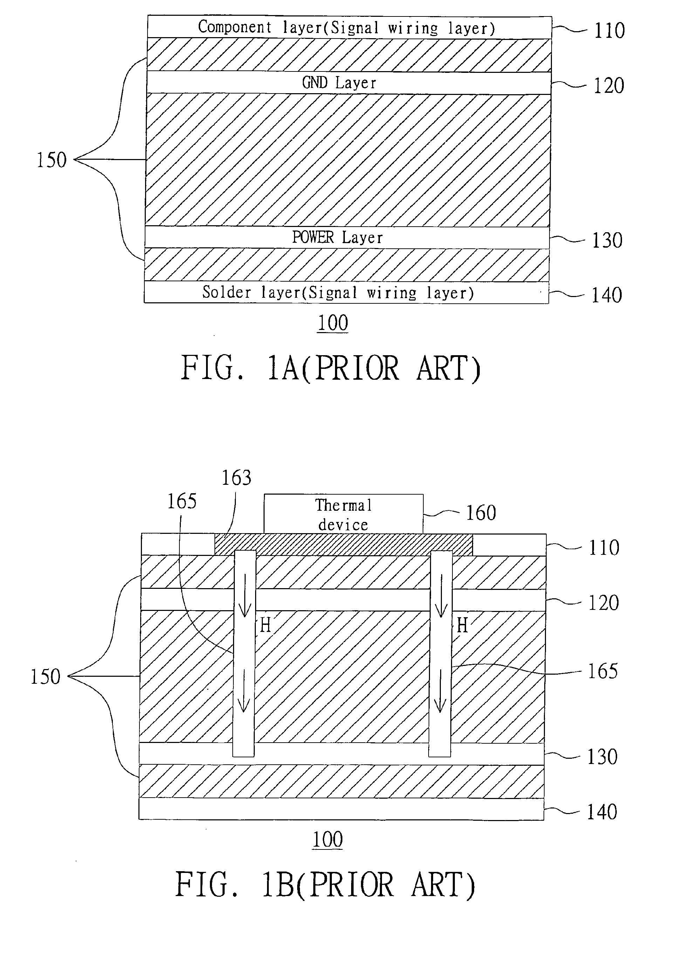

FIG. 1A is a front elevation of a conventional printed circuit board structure. Referring to FIG. 1A, the printed circuit board 100, such as a computer motherboard, has four copper conduction layers from top to bottom including a component layer 110, a ground (GND) layer 120, a power layer 130, and a solder layer 140 in order. Insulation layers 150, such as composed of glass fibers, are disposed between the conduction layers for insulation. The component layer 110 is a signal wire layer for configuring copper wires coupled to operation devices (not shown in the figure) on the printed circuit board 100. Conventionally, the solder layer 140 is also a signal wire layer for configuring copper wires and transmitting signals. Moreover, the GND layer 120 and the POWER layer 130 are both copper conduction plates having a large area, and are generally disposed as inner layers of the printed circuit board 100 and signal references for the component layer 110 and solder layer 140. The GND layer 120 and the POWER layer 130 can be stacked in an opposite order.

As shown in FIG. 1B, a thermal device 160 is disposed on the component layer 110, for example, an elementary device, such as a resistor, a capacitance, an inductance, or a transistor, or a complicated integrated circuit (IC), such as an ASIC IC, memory or a general IC, or a main thermal device on a motherboard, such as a CPU, a south or north bridge chip set, or a power processing circuit device. The heat H generated by the thermal device 160 is conducted to the GND layer 120 or the POWER layer 130 through the wire 163 and the vias 165 while the GND layer 120 and the POWER layer 130 can also generate heat as a loading current flows by. However, on a conventional design of a printed circuit board structure, the GND layer 120 and the POWER layer 130 are disposed as inner layers of the printed circuit board 100. Therefore, the large amount of heat accumulated in the GND layer 120 and the POWER layer 130 cannot be dissipated, thereby increasing the temperature of the whole printed circuit board 100 and causing system instability.

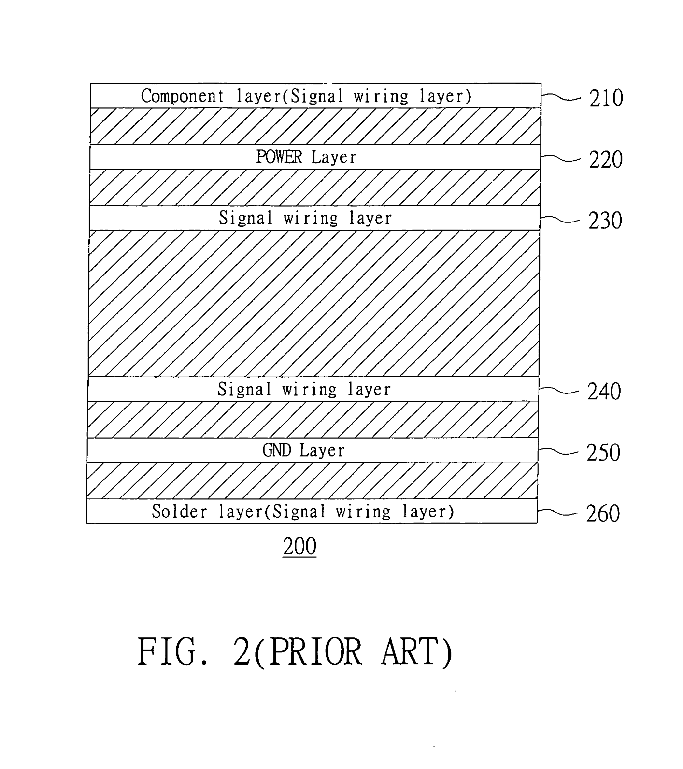

Besides, as shown in FIG. 2, the printed circuit board 200, applied to a highly complicated circuit, such as a memory module and a notebook computer motherboard, generally has six copper conduction layers including a component layer 210, a POWER layer 220, signal wire layers 230 and 240, a GND layer and a solder layer 260. The component layer 210 and the solder layer 260 are respectively located at the upper surface and the lower surface of the printed circuit board 200 and used as signal wire layers, while the POWER layer 220 and the GND layer 250 are disposed as inner layers. Therefore, heat dissipation issue mentioned above also occurs on the conventional design of six-layer printed circuit board 200.

In the past, many methods for solving the heat dissipation issue of the printed circuit board are provided to reduce the heat, for example, by setting a heat sink, a cooler, or a heat pipe in a passive way, or by the processor power management in an active way. However, these methods cost a lot but have limited heat dissipation. Furthermore, some methods of the prior arts trade off the computer performance and heat dissipation.

### SUMMARY OF THE INVENTION

It is therefore an object of the invention to provide a printed circuit board structure. The signal reference layer, such as a POWER layer or a GND layer is exposed at the surface of the printed circuit board. Through the large-area copper material of the signal reference layer having a good conduction feature and exposed to the air, the heat generated by the thermal devices on the printed circuit board can be dissipated by convection, thereby achieving heat dissipation purpose without increasing manufacturing cost.

The invention achieves the above-identified object by providing a printed circuit board structure including a first signal reference layer exposed at a surface of the printed circuit board.

The invention achieves the above-identified object by providing a printed circuit board structure having a first surface and a second surface, and including a first signal wire layer, a first signal reference layer and a second signal reference layer. The first signal wire layer is located at the first surface of the printed circuit board. The first signal reference layer is located at the second surface of the printed circuit board. The second signal reference layer is located between the first signal wire layer and the first signal reference layer.

The invention achieves the above-identified object by providing a printed circuit board structure having a first surface and a second surface, and including a first signal wire layer, a first signal reference layer, a second signal reference layer, a second signal wire layer, and a third signal reference layer. The first signal wire layer is located at the first surface of the printed circuit board. The first signal reference layer is located at the second surface of the printed circuit board. The second signal reference layer is located between the first signal wire layer and the first signal reference layer. The second signal wire layer is located between the first signal reference layer and the second signal reference layer while the third signal reference layer is located between the first signal reference layer and the second signal wire layer. The first signal wire layer is electrically coupled to the first signal reference reference layer through a via.

Other objects, features, and advantages of the invention will become apparent from the following detailed description of the preferred but non-limiting embodiments. The following description is made with reference to the accompanying drawings.

### BRIEF DESCRIPTION OF THE DRAWINGS

FIG. 1A (Prior Art) is a front elevation of a conventional printed circuit board structure.

FIG. (Prior Art) 1 B is a schematic diagram of the conventional printed circuit board with heat generated by a thermal device conducted to a POWER layer.

FIG. 2 (Prior Art) is a front elevation of a conventional six-layer-type printed circuit board structure.

FIG. 3A is a front elevation of a printed circuit board structure according to a first embodiment of the invention.

FIG. 3B is a schematic diagram of the printed circuit board with heat generated by a thermal device conducted to a POWER layer for dissipation according to the first embodiment of the invention.

FIG. 4A is a front elevation of a printed circuit board structure according to a second embodiment of the invention.

FIG. 4B is a schematic diagram of the printed circuit board with heat generated by a thermal device conducted to a POWER layer for dissipation according to the second embodiment of the invention.

### DETAILED DESCRIPTION OF THE INVENTION

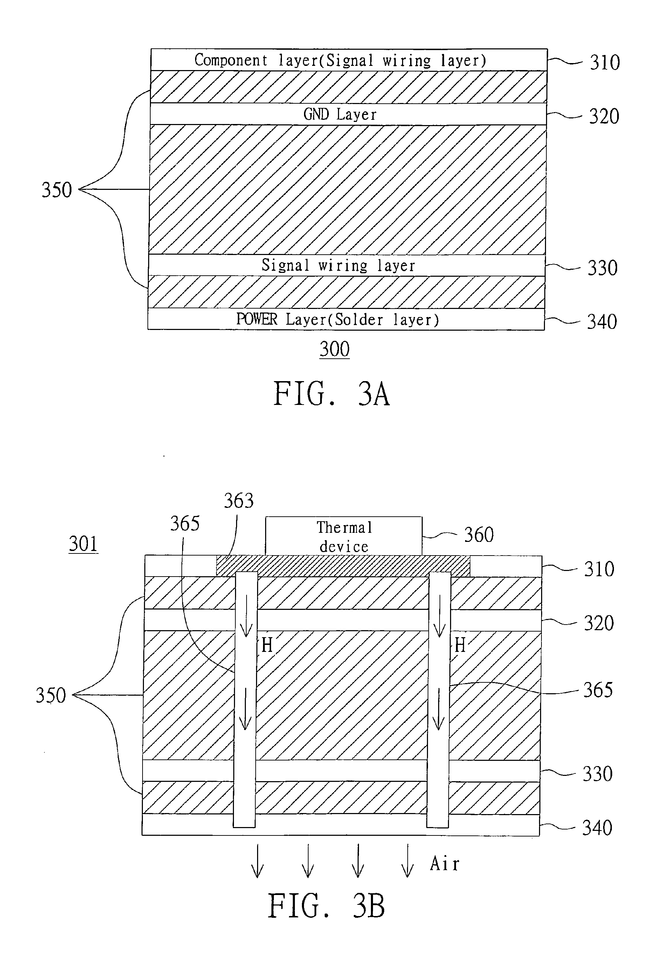

FIG. 3A shows a front elevation of a printed circuit board structure according to a first embodiment of the invention. The printed circuit board 300 provides an example of a four-layer symmetry-type design, which has four conduction layers from top to bottom including a component layer 310, a GND layer 320, a signal wire layer 330 and a POWER layer 340. The conduction layers can be made of any conduction materials, such as copper or gold. Insulation layers 350 are disposed between the conduction layers for insulation, wherein the insulation layers are made of insulation materials having a specific dielectric coefficient, such as glass fibers. The component layer 310, a kind of signal wire layer, is exposed at the surface of the printed circuit board 300, for configuring wires coupled to the operation devices (not shown in the figure) on the printed circuit board 300. The GND layer 320 is used as a signal reference layer for the component layer 310 and disposed close to the component layer 310 in the embodiment.

By comparing the prior art, the printed circuit board 300 has the POWER layer 340 exposed on the lower surface of the printed circuit board 300 and the POWER layer 340 is utilized as solder layer. The signal wire layer 330 is placed on the inner layer and the POWER layer 340 is utilized as signal reference layer for dissipation.

By viewing FIG. 3B, in the printed circuit board 301, a thermal device 360 is disposed on the component layer 310, for example, an elementary device such as a resistor, a capacitance, or a complicated integrated circuit (IC) such as an ASIC IC or a general IC, or a main thermal device on a motherboard, such as a CPU, a switching regulator or a chip set. The heat H generated by the thermal device 360 is conducted to the POWER layer 340 through the wire 363 and the via 365. Or the heat H generated by the GND layer 320 as a loading current flows by is conducted to the POWER layer 340 through the via 365. Owing that the POWER layer 340 of the printed circuit board 301 is ingeniously disposed at the lower surface of the printed circuit board 301, by using the large-area copper of the POWER layer 340, having a good heat conduction feature and exposed to the air, the heat generated by the thermal device 360, the GND layer 320, and the POWER layer 340 can be dissipated by convection to achieve a good heat dissipation effect.

As mentioned above, although the POWER layer 340 used as a solder layer is taken as an example in the invention, the printed circuit board 300 of the invention can have the GND layer 320 and the POWER layer 340 disposed in an opposite order, that is, the GND layer 320 is disposed as a solder layer at the lower surface of the printed circuit board while the POWER layer 340 and the GND layer 320 are respectively signal reference layers for the component layer 310 and the signal wire layer 330. Or the printed circuit board is not limited to a symmetry-type design. For example, the signal wire layer 330 can also be disposed close to the GND layer 320 located above and uses the GND layer 320 as a signal reference layer, or the signal wire layer 330 can also even be disposed as another signal reference layer. As long as the signal reference layer such as the GND layer or the POWER layer is exposed at the surface of the printed circuit board, the purpose of dissipating heat generated by the above-mentioned thermal device, the POWER layer, and the GND layer can be achieved, and all these are thus not apart from the scope of the invention.

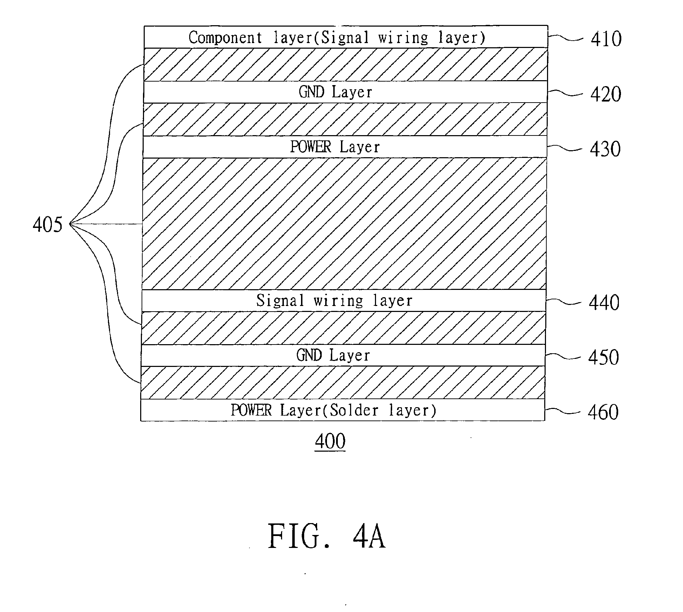

Referring to FIG. 4A, a front elevation of a printed circuit board structure according to a second embodiment of the invention is shown. The printed circuit board 400, a symmetry-type design, has six conduction layers including a component layer 410, a GND layer 420, a POWER layer 430, a signal wire layer 440, a GND layer 450, and a POWER layer 460 in order from top to bottom. The conduction layers can be made of any conduction material, such as copper or gold. Insulation layers 405 are disposed between the conduction layers for insulation, wherein the insulation layers 405 are made of an insulation material having a specific dielectric coefficient, such as glass fibers. The component layer 410 is a kind of signal wire layer exposed at the upper surface of the printed circuit board 400 for configuring wires coupled to the operation devices (not shown in the figure) on the printed circuit board 400. The GND layer 420 is used as a signal reference layer for the component layer 410 and disposed close to the component layer 410.

The printed circuit board of six-layer type has additionally the POWER layer 430 and the GND layer 450 as compared to the above-mentioned printed circuit board 300 of four-layer type. However, the printed circuit board can have other six-layer-type design. The GND layers 420 and 450 are respectively disposed to be the signal reference layers for the component layer 410 and the signal wire layer 440 and the signal quality in a whole can be improved. Due to the extra conduction areas provided by the POWER layer 430 and the GND layer 450, the equivalent resistance of the whole conduction layer can be lowered down and the heat generated in the printed circuit board 400 as a large amount of current flows by the conduction layer can thus be reduced.

Different from the prior art, the POWER layer 460 of the printed circuit board 400 in the embodiment is exposed at the lower surface of the printed circuit board 400 to be a solder layer, and the signal wire layer is disposed as an inner layer and uses the GND layer as a signal reference layer so as to provide a better heat dissipation effect.

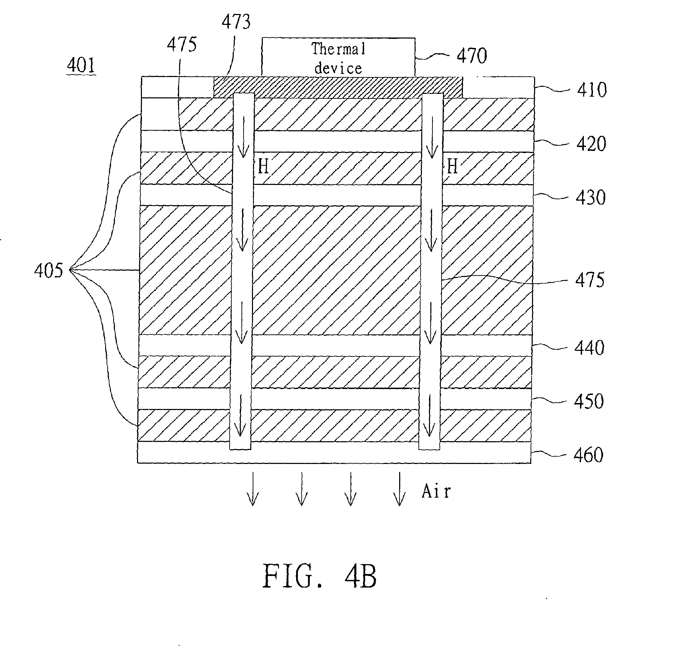

As shown in FIG. 4B, in the printed circuit board 401, the heat H generated by the thermal device 470 disposed on the component layer 410, such as a CPU, a switching regulator or a chip set, is conducted to the POWER layer 460 through the wire 473 and vias 475, or the heat H generated by the GND layer 420, the POWER layer 430, and the GND layer 450 as a loading current flows by is conducted to the POWER layer through the vias 475. Owing that the POWER layer 460 is ingeniously disposed at the lower surface of the printed circuit board 401 in the embodiment, the heat generated by the thermal device 470, the GND layer 420, the POWER layer 430, the GND layer 450, and the POWER layer 460 can be effectively dissipated by convection to achieve a good heat dissipation effect by using the large area of conduction metal of the POWER layer 460 having a good conduction feature and exposed to the air.

As mentioned above, although the POWER layer 460 used as a solder layer is taken as an example, the printed circuit board of the invention can also use the GND layer to be a solder layer, or the third layer, the POWER layer 430 can also be disposed as a signal wire layer, and the component layer 410 can be used as a signal reference layer for both the component layer 410 and the GND layer 420. As long as a signal wire layer such as the GND layer or the POWER layer is exposed at the surface of the printed circuit board to achieve the purpose of dissipating the heat generated by the above-mentioned thermal device, the POWER layer and the GND layer, any other printed circuit board structure of six-layer type is not apart from the scope of the invention.

Furthermore, although the four-layer type and six-layer type of printed circuit boards are respectively taken as examples in the two embodiments mentioned above, the invention is not limited thereto. As long as the solder layer located at the surface of the printed circuit board is designed by using conduction materials, such as the GND layer or the POWER layer having a large area of copper, the heat generated by the printed circuit board can be dissipated by convection, or the conduction impedance as well as the heat of the printed circuit board can be reduced by increasing the layer number and thus the conduction area of the POWER layer and the GND layer. Therefore, all these printed circuit board structures no matter number of the layers they have are not apart from the scope of the skill.

As shown in Table 1, a temperature comparison is conducted at twenty corresponding test points between a conventional four-layer-type motherboard and the six-layer-type motherboard having a POWER layer exposed to the air with both of them having a similar device configuration. The selected test points include a capacitance, a coil, a MOSFET electronic switch, and so on, while no heat sink is disposed near each test point. According to the experiment result, the temperatures (□) at the twenty test points on the motherboard of the invention with the POWER layer exposed to the air shown in the left column are all lower than those at the corresponding test points on the conventional motherboard shown in the right column, and the temperature reduction rate reaches about 30% (such as the fifth test point) as the POWER layer is exposed to the air. Obviously, the motherboard of the invention can have a better heat dissipation effect.

**Table 1**

| Test Point | Six-layer-type motherboard of the invention | Four-layer-type motherboard in prior art |
|---|---|---|
| 1 | 73.0 | 97.0 |
| 2 | 73.0 | 100.0 |
| 3 | 80.0 | 107.0 |
| 4 | 80.0 | 102.0 |
| 5 | 70.0 | 98.0 |
| 6 | 68.0 | 83.0 |
| 7 | 76.0 | 95.0 |
| 8 | 76.0 | 92.0 |
| 9 | 72.0 | 78.0 |
| 10 | 64.0 | 72.0 |
| 11 | 67.0 | 72.0 |
| 12 | 67.0 | 75.0 |
| 13 | 86.0 | 88.0 |
| 14 | 76.0 | 84.0 |
| 15 | 71.0 | 78.0 |
| 16 | 64.0 | 77.0 |
| 17 | 65.0 | 82.0 |
| 18 | 65.0 | 83.0 |
| 19 | 61.0 | 74.0 |
| 20 | 77.0 | 80.0 |

The printed circuit board structure disclosed by the above-mentioned two embodiments of the invention has the following advantages. The GND layer or the POWER layer having a large area and made of a heat conduction material is ingeniously exposed at the surface of the printed circuit board and thus the heat generated by the printed circuit board can be effectively dissipated by convection. Moreover, it is only required that the solder layer forming process is changed to form the POWER layer or the GND layer in the original printed circuit board manufacturing process or the process for forming a signal wire layer as the solder layer is exchanged with the POWER layer or GND layer forming process. Therefore, no extra manufacturing cost has to be charged.

While the invention has been described by way of example and in terms of two preferred embodiments, it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A printed circuit board structure, comprising:
a first signal reference layer, exposed at a surface of the printed circuit board.

2. The printed circuit board structure according to claim 1, further comprising a first signal wire layer exposed to the other surface of the printed circuit board.

3. The printed circuit board structure according to claim 2, further comprising a second signal reference layer located between the first signal reference layer and the first signal wire layer.

4. The printed circuit board structure according to claim 3, further comprising a second signal wire layer located between the first signal reference layer and the second reference layer.

5. A printed circuit board structure having a first surface and a second surface, comprising:
a first signal wire layer, located at the first surface of the printed circuit board;
a first signal reference layer, located at the second surface of the printed circuit board; and
a second signal reference layer, located between the first signal wire layer and the first signal reference layer.

6. The printed circuit board structure according to claim 5, wherein the first signal wire layer is electrically coupled to the first signal reference layer through a via.

7. The printed circuit board structure according to claim 6, further comprising a second signal wire layer located between the second signal reference layer and the first signal reference layer and the second signal wire layer is electrically coupled to the first signal reference layer through a via.

8. The printed circuit board structure according to claim 7, wherein the second signal wire layer is relatively closer to the first signal reference layer.

9. The printed circuit board structure according to claim 7, wherein the second signal wire layer is relatively closer to the second signal reference layer.

10. The printed circuit board structure according to claim 9, wherein the second signal reference layer is a GND layer.

11. A printed circuit board structure having a first surface and a second surface, comprising:
a first signal wire layer, located at the first surface of the printed circuit board;
a first signal reference layer, located at the second surface of the printed circuit board;
a second signal reference layer, located between the first signal wire layer and the first signal reference layer;
a second signal wire layer, located between the first signal reference layer and the second signal reference layer; and
a third signal reference layer, located between the first signal reference layer and the second signal wire layer;
wherein the first signal wire layer is electrically coupled to the first signal reference layer through a via.

12. The printed circuit board structure according to claim 11, wherein the third signal reference layer is a GND layer.

13. The printed circuit board structure according to claim 11, further comprising a third signal wire layer, located between the second signal reference layer and the second signal wire layer and relatively closer to the second signal reference layer.

14. The printed circuit board structure according to claim 11, further comprising a forth signal reference layer located between the second signal reference layer and the second signal wire layer and relatively closer to the second signal reference layer.

15. The printed circuit board structure according to claim 1, 5 or 11 wherein the first signal reference layer is a POWER layer.

16. The printed circuit board structure according to claim 1, 5 or 11 wherein the first signal reference layer is a GND layer.

17. The printed circuit board structure according to claim 3 or 11 wherein the second signal reference layer is a GND layer.
